# EUROPEAN PATENT APPLICATION

(11) **EP 1 986 229 A1**
(43) Date of publication of application: **29.10.2008**
(21) Application number: 07290528.4
(22) Date of filing: 27.04.2007
(51) Int. Cl.: H01L 21/762

(54) **Method for manufacturing compound material wafer and corresponding compound material wafer**

(71) Applicant: S.O.I. TEC Silicon on Insulator Technologies, 38190 Bernin (FR)
(72) Inventor: Reynaud, Patrick, 38400 St. Martin D'Heres (FR); Kononchuk, Oleg, 38000 Grenoble (FR)
(74) Representative: Grünecker, Kinkeldey, Stockmair & Schwanhäusser Anwaltssozietät

(57) **Abstract**

The invention relates to methods for manufacturing compound material wafers, in particular silicon on insulator type wafers, comprising the steps of providing a donor substrate, forming an insulating layer, providing a handle substrate, creating a predetermined splitting area in the donor substrate, attaching the donor substrate to the handle substrate and detaching at the predetermined splitting area to achieve the compound material wafer. In order to be able to more often reuse the remainder of the donor substrate in subsequent manufacturing runs, the invention is characterized by the fact that the insulating layer provided on the donor substrate has a maximum thickness of 500 Å, or that the insulating layer is provided by deposition or only on the handle substrate. In addition, a silicon on silicon type wafer fabrication method is also disclosed.

## Description

The invention relates to a method for manufacturing compound material wafers, in particular silicon on insulator type wafers and corresponding compound material wafers.

Compound material wafers, in particular silicon on insulator (SOI) type wafers, are semiconductor substrates which, in modern semiconductor devices, play a decisive role to ensure ever higher speed as smaller dimensions are enabled. The process to fabricate such compound material wafers has, however, to satisfy at least two basic requirements. First, a good crystalline quality needs to be satisfied over essentially the entire surface of the wafer in the layered structure and, second, the fabrication needs to be carried out without incurring excessive costs.

One way to satisfy the above mentioned requirements is the so called Smart-Cut^{™} type fabrication process in which a layer from a donor substrate is transferred onto a handle substrate. This is achieved by bonding the two substrates and detaching the donor substrate at a predetermined splitting area, which has previously been formed in the initial donor substrate. The predetermined splitting area is created beforehand by implanting atomic species, like hydrogen and/or rare gas ions into the donor substrate. This approach has the advantage that the donor substrate from which a layer is transferred from fabrication run to fabrication run, is reused several times. It appeared, however, that, from run to run, the crystalline quality of the transferred layer deteriorated. As a consequence, a certain number of additional measures have been proposed to overcome this problem.

JP 11-297583, proposes additional process steps, like polishing the donor substrate, to remove the surface step at the edge of the wafer. This step is present after the transfer of a layer onto the handle substrate. Then a second finishing polishing step is carried out before the remainder of the donor substrate is reused as a new donor substrate in a subsequent fabrication run. US 2003/029957 alternatively proposes, prior to polishing, additional heat treatment steps of the reclaimed donor wafer. It appeared, however, that even though improvements in the crystalline quality can be achieved by the additional process steps, the number of reuses still remained unsatisfactory low.

US 6,211,041 does not deal with the reuse of donor substrates, but discloses an approach which consists in providing, right from the beginning, a silicon substrate with a low oxygen content preventing the creation of crystal defects. However, like for the other two methods, special additional steps are necessary beforehand to create the silicon substrate with reduced oxygen content and, in addition, the number of possible reuses of the donor substrate still remained unsatisfactory low.

In view of the abovementioned problem and the unsatisfactory measures in the prior art to overcome the problem, it is the object of the present invention to provide a method for manufacturing compound material wafers which allows an increased number of reuses of the used donor substrate and, at the same time, allows the fabrication of good quality compound material wafers without the necessity of further additional treatment steps.

This object is achieved with the method for manufacturing compound material wafers according to the features of claim 1. Surprisingly, it was found out that by keeping the thickness of the insulating layer formed over the donor substrate, thus the substrate from which the transferred layer originates, at values not exceeding 500 Å, the crystalline quality of the donor substrate remained better compared to the methods known from the prior art, and this from fabrication run to fabrication run. In addition, the necessity of extensive additional steps, like proposed in the state of the art, became obsolete. Using the inventive method, surface polishing steps to remove the surface step and surface roughness inherent to the Smart-Cut^{™} technology can be sufficient.

According to a preferred embodiment the inventive method can further comprise a step of forming a second insulating layer over the handle substrate prior to step d). For those applications for which a thicker insulating layer is necessary, the lacking thickness can be provided via an insulating layer on the handle substrate, thereby keeping the crystalline quality of the donor substrate, so that the invention is not limited to applications with thin insulating layers.

According to a variant, the inventive method can further comprise a step of depositing a third insulating layer on the first insulating layer prior to step d). In that case preferably the deposition shall take place at low temperature, in particular in a temperature range between 400°C and 600°C. It was observed that even though the insulating layer on the donor substrate became thicker, the crystalline quality, from fabrication run to fabrication, remained better compared to the prior art methods preparing compound material wafers having the same insulating layer thickness, but which were entirely thermally grown. This advantage is attributed to the fact that the total thermal budget applied is lower than in case the whole thickness is achieved by a thermal process.

According to a preferred embodiment, the first insulating layer can be a thermal insulating layer formed by oxidation. It was found out that one of the decisive steps concerning the number of possible reuses, is the thermal treatment step to obtain the insulating layer as this step leads to a decrease in the crystalline quality of the donor substrate. However, as long as the thickness of the first insulating layer is kept low, a thermal treatment can still be used, thereby taking advantage of a method that is well understood, easy to carry out and that furthermore provides an interface between the top layer and the buried oxide in the final structure which has a high quality compared to other layer forming processes. At the same time the advantageous effects mentioned above can still be achieved.

Depending on the thickness of the thermally grown layer it is even possible to carry out the layer forming process step at temperatures of up to 1000°C, to speed up the process. According to a variant it is preferable to keep the growth temperature at values of less than 950°C, preferably at values of less than 850°C, in which case the time to grow a layer of the same thickness is longer, however, the crystalline quality of the donor substrate remains better.

According to a preferred embodiment, in step d) the attachment can occur at the surface of the first or third insulating layer of the donor substrate. Thus, once the first or third insulating layer is provided, the donor substrate does not see a further layer forming process which could affect its crystalline quality. Thus, the number of reuses of the donor substrate can be further enhanced. If further layers are necessary in the compound material wafer, these additional layers are preferably provided over the handle substrate.

The object of the invention is also achieved with the method according to claim 6. Like already mentioned above, it appeared that the decisive step concerning the number of possible reuses of the donor substrate is the step of forming the insulating layer over the initial donor substrate. Surprisingly a deposition process to form the insulating layer lead to a higher number of possible reuses for the same insulator thickness than compared to cases where the insulting layer was formed using the standard thermal process.

According to a preferred embodiment, the inventive method can furthermore comprise a step f) of densifying, in particular using a thermal treatment under a neutral atmosphere, the insulating layer after step e). Typically, deposited layers are less dense than thermally grown layers, e.g. they are porous, but this inconvenience can be overcome by carrying out a thermal treatment under neutral atmosphere, in particular during a few hours. As the densification takes place after detachment from the donor substrate has occurred, the crystalline quality of the donor substrate can not be negatively affected by this thermal treatment.

Advantageously the depositing step can be carried out at low temperature, in particular at less than 750°C, in particular in the range of 400°C to 600°C. In this temperature range throughput can be kept high.

According to a preferred embodiment, in step d) the attachment can occur at the surface of the first insulating layer of the donor substrate. In this way it is ensured that the donor substrate does not see any further thermal treatment which may influence its crystalline quality, so that the number of reuses of the donor substrate can be further enhanced. If further layers are necessary in the compound material wafer, these additional layers are preferably provided over the handle substrate.

The object of the invention is furthermore achieved with the method according to claim 10. In this alternative method the insulating layer is no longer formed on the donor substrate like in the prior art, but on the handle substrate. The transferred layer is provided by the donor substrate, which according to this embodiment is not subjected to the usual thermal treatments to obtain an insulating layer, so that the crystalline quality of the donor substrate is not affected by any thermal budgets linked to insulating layer forming process. As a consequence, the number of reuses of the donor substrate is higher than compared to the prior art.

Preferably, in step e) attachment can occur at the surface of the donor substrate. In this case it is ensured that the donor substrate does not see a thermal budget in combination with a layer forming process concerning the donor substrate.

Preferably for all of the abovementioned methods, the first insulating layer and/or second insulating layer and/or third insulating layer can be a silicon dioxide layer. For silicon dioxide layers, the negative impact on the crystalline quality of the donor substrate in combination with a silicon wafer lead to unsatisfactory numbers of reuses of the donor substrate, so that, for this material choice, the advantageous of any of the above mentioned methods are even more pronounced.

The object of the invention can furthermore be achieved with the method according to claim 13. In this alternative method neither on the one nor on the other substrate an insulating layer is provided, thus, the donor substrate does not see the thermal budget usually applied to grow a thermal insulating layer like in the prior art. Thus, the deterioration of the crystalline quality can be prevented, and the number of reuses of the donor substrate rises in turn. Such hybrid orientation substrates, in which the crystalline direction of the transferred layer is different to the one of the handle substrate, are interesting materials as they provide the possibility to optimize the electron or hole mobilities by taking into account the crystal orientation dependant mobilities of the carriers.

Advantageously, in step d), attachment can occur directly at the surface of the donor substrate. In this way it is ensured that indeed the donor substrate does not see any thermal budget linked to a layer-forming step. If necessary, any further layers needed in the material compound wafer, can be formed on the handle substrate.

All inventive methods have in common that it is possible to repeat them more than three times, preferably five to ten times, wherein the remainder of the donor substrate is reused as donor substrate in the subsequent manufacturing runs. As mentioned above, the crystalline quality of the donor substrate can be kept high, so that it is indeed possible to reuse it several times and in particular, more often than it was common in the prior art and this without the necessity of extensive additional reclaiming steps.

The object of the invention is furthermore achieved with the reused donor substrate obtained according to the abovementioned method.

Specific embodiments of the present invention will become more apparent from the present description with reference to the accompanying drawings wherein:
Figure 1 illustrates a first embodiment of the inventive method for fabricating compound materials,
Figure 2 illustrates a second embodiment of the inventive method for fabricating compound material wafers,
Figure 3 illustrates a third embodiment of the inventive method for fabricating compound material wafers,
Figure 4 illustrates a fourth embodiment of the inventive method for fabricating compound material wafers,
Figure 5 illustrates a fifth embodiment of the inventive method for fabricating compound material wafers, and
Figure 6 illustrates a sixth embodiment of the inventive method for fabricating compound material wafers and which is applied to hybrid orientation wafers.

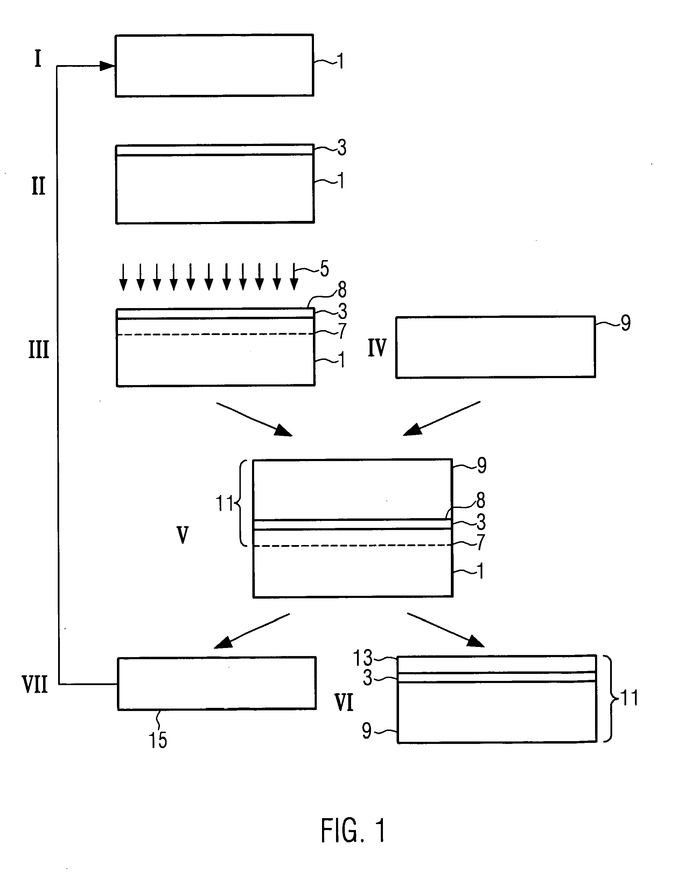

Figure 1 illustrates a first embodiment of the inventive method for manufacturing compound material wafers. The method will be described for a silicon on insulator (SOl) type compound material wafer. This, nevertheless, only serves as an example and the inventive method is also applicable to other types of material compound wafers.

Step I of the inventive method consists in providing an initial donor substrate 1, in this embodiment a silicon wafer, according to step a) of claim 1. Step II illustrates a step of forming an insulating layer 3 on the silicon wafer 1, according to step b) of claim 1. Here the insulating layer 3 is a silicon dioxide layer (SiO₂), which is formed by a thermal treatment under oxidizing conditions. According to this first embodiment of the invention the insulating layer 3 is thermally grown to a thickness of at most 500 Å.

In Step III, corresponding to step c) of claim 1, atomic species 5, in particular, hydrogen or rare gas ions like helium, are implanted under predetermined dose and energy conditions through the insulating layer 3 to create a predetermined splitting area 7 inside the donor substrate 1. As can be seen, this predetermined splitting area 7 is essentially parallel to the main surface 8 of substrate 1. Eventually, implanting using one species is accompanied by a second implantation of a different species, wherein the first species may be helium and the second species hydrogen.

Step IV of Figure 1 illustrates the step of providing a handle substrate 9, for instance, a silicon wafer.

In the subsequent Step V, corresponding to step d) of claim 1, the donor substrate 1 together with its insulating layer 3 is bonded to the handle substrate 9. Bonding occurs such that the insulating layer 3 is sandwiched between the donor substrate 1 and the handle substrate 9. In particular, attachment occurs at surface 8 of the insulating layer 3.

A detachment treatment is then carried out during which detachment occurs at the predetermined splitting area 7, such that the silicon on insulator wafer 11 is created. The detachment treatment is preferably a heat treatment, due to which, detachment occurs. However other possibilities like mechanical or a mixture are also possible.

Step VI illustrates the silicon on insulator wafer 11 that comprises the handle substrate 9, the insulating layer 3 and the transferred layer 13 that originated from the donor substrate 1.

The remainder 15 of the donor substrate 1, illustrated in Step VII, can then be reused as a new donor substrate 1 in Step I (see above). Prior to the reuse, the remainder 15 of the donor substrate 1 can undergo a certain number of recycling steps usually consisting in polishing and/or cleaning like known the in prior art.

Once transferred, the transferred layer 13 can be treated to reduce its thickness to the final desired thickness and to improve its surface roughness. This finishing operation comprises, for instance, annealing steps.

In the prior art, it was not possible to reuse the remainder 15 of the donor substrate without extensive additional process steps to get rid of or reduce oxygen precipitates, considered to be responsible for a decrease in crystalline quality, to a tolerable level in order to ensure a sufficiently good crystalline quality. Reuse was just possible for manufacturing thick device layers, with thicknesses larger than the size of the defects, but was limited to two or three times. Beyond that, too many defects were observed in the final SOl products, in particular, for wafers with large diameters, in particular, diameters of 300 mm, for which it was difficult and costly to obtain sufficient crystalline quality for allowing recycling of the donor wafers of more than three times.

It was now found out that by limiting the thickness of the insulating layer 3 to at most 500 Å, the crystalline quality of the remainder 15 of the donor substrate can be kept at a sufficiently high level, so that the donor substrate can be reused more than three times.

By limiting the maximum thickness of SiO₂ to 500 Å, the number of HF defects occurring when an SOl wafer 11 is dipped into an HF solution, which etches away the naturally grown silicon dioxide layer and which leads to holes at positions of oxygen precipitates, were reduced. Thus, one donor substrate 1 when used according to the invention can now be reused more than three times, in particularly five to ten times. Furthermore, no further oxygen precipitate reducing or limiting steps, like in the prior art, are necessary.

The achievement of the invention, namely, that it is now possible to carry out the compound material wafer manufacturing process such that the negative impact of oxygen precipitates leading to HF defects can be limited, brings the further advantage that the transferred layers 13 can have a reduced thickness. In particular, it becomes possible to prepare transferred layers 13 which, after thinning, lead to device layers with a thickness of less than 1000 Å even from donor substrates 1 which are reused for the fourth, fifth or even tenth time.

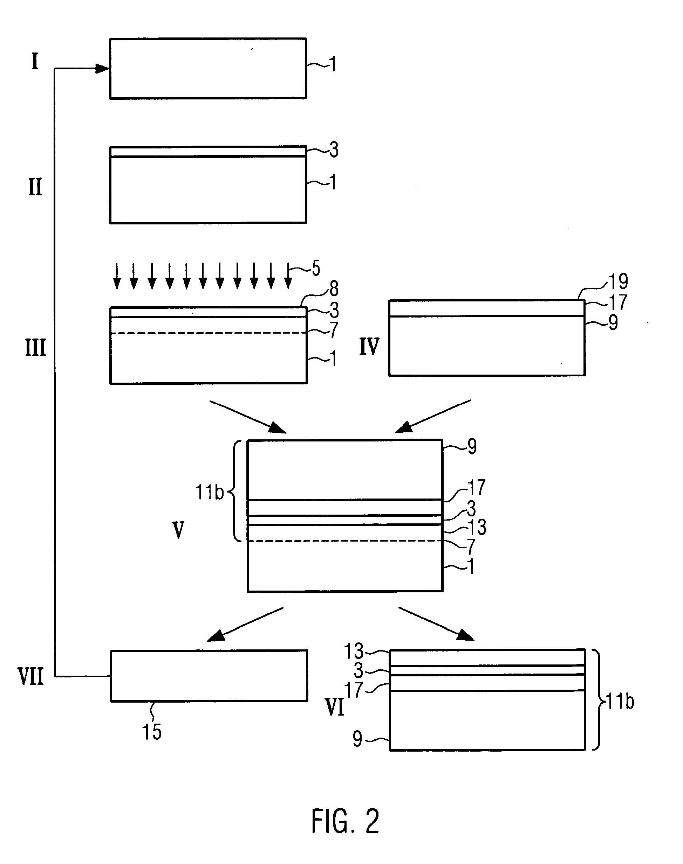

In the following, Figure 2 illustrates the second embodiment of the inventive method for manufacturing compound material wafer. In this embodiment Steps I to III correspond to those already described above for the first embodiment and their detailed description is omitted but incorporated herewith by reference.

Step IV again illustrates the provision of a handle substrate 9, for instance, a silicon wafer like already disclosed above in the first embodiment. In the second embodiment, however, a second insulating layer 17, in particular a silicon dioxide layer, is provided on one of the main surfaces of the handle substrate 9. This additional layer 17 can be either grown thermally or provided by a deposition process.

The subsequent Step V, corresponding to step d) of claim 1 then consists in attaching, in particular by bonding, the donor substrate 1 together with its insulating layer 3 to the handle substrate 9 together with its second insulating layer 17. Here the attachment occurs at the main surface 8 of the first insulating layer 3 and surface 19 of the second insulating layer 17 (see step IV).

Then, like in the previous embodiment, a detachment step is carried out to obtain the desired material compound wafer, that is the silicon on insulator layer 11 b, comprising the transferred layer 13, the first insulating layer 3 originating from the donor substrate 1, the second insulating layer 17 and the handle substrate 9, like shown in Step VI.

Step VII corresponds to step VII of the first embodiment, and its detailed description will not be repeated again but is incorporated again by reference.

In addition to the advantages achieved with the first embodiment, the second embodiment enables the formation of an insulating layer being thicker than 500 Å, namely corresponding to the combined thickness of the first and second insulating layer 3 and 17. Preferably the two layers are of the same material, for instance silicon dioxide. Depending on the application for which the compound material wafer 11 will be used, the thickness can be freely chosen by adapting the thickness of the second insulating layer 17. Due to the fact that the second insulating layer 17 is provided on the handle substrate 9, the donor substrate 1 itself does not see a further thermal budget, so that the crystalline quality is not affected by the provision of the second insulating layer 17.

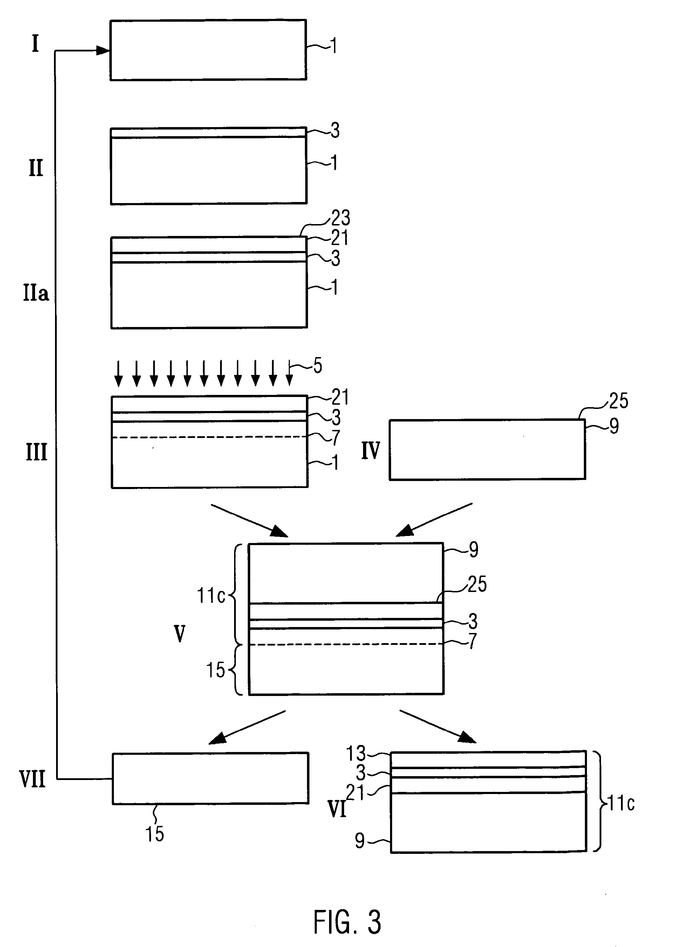

Figure 3 illustrates a third embodiment of the inventive method for fabricating a compound material wafer. In this embodiment Steps I and II correspond to Steps I and II of the previous embodiments, their description will therefore not be repeated again but is incorporated herewith by reference. Between Steps II and III of the previous embodiments, embodiment 3 has a further Step IIa during which a third insulating layer (21) is deposited onto the first insulating layer 3.

In Step III, like in the previously described Steps III, atomic species 5, in particular, hydrogen or rare gas ions like helium, are implanted under predetermined dose and energy conditions through the first and second insulating layers 3, 21 to create a predetermined splitting area 7 inside the donor substrate 1.

Step IV is the same as in the first embodiment.

In Step V, like in the previous embodiments, the donor substrate 1 together with its first and third insulating layers 3, 21 is attached to the handle substrate 9, in particular by bonding. Attachment occurs in this embodiment between the surface of the third insulating layer 23 and the surface 25 of the handle substrate 9.

Then, like in the previous embodiments, a detachment treatment is carried out during which detachment occurs at the predetermined splitting area 7, such that a silicon on insulator wafer 11 c is achieved, which is illustrated by step VI The silicon on insulator wafer 11c comprises the handle substrate 9, the insulating layer 3, the third insulating layer 21 and the transferred layer 13 which originated from the donor substrate 1.

Step VII then corresponds again to Step VII of the previous embodiments.

The third insulating layer 21 is a deposited layer, wherein deposition is preferably carried out at relatively low temperatures, in particular, at less than 750°C, more in particular, in a range of 400°C - 600°C. By doing so the thermal budget seen by the donor substrate 1 is kept low, so that the donor substrate can still be reused more than 3 times, in particular five to the times.

Like in the second embodiment, it again becomes possible to obtain an insulating layer with a thickness, which can be freely chosen as a function of the applications for which the compound material wafer is intended for, as the insulating layer thickness corresponds to the sum of the thickness of the first insulating layer 3 and the thickness of the third insulating layer 17, the later having a thickness that can be chosen freely.

Apart from that, all the other advantages and variants as disclosed with respect to the first and second embodiments are also achieved in this embodiment.

According to advantageous variants the embodiments 1 to 3 can be freely combined.

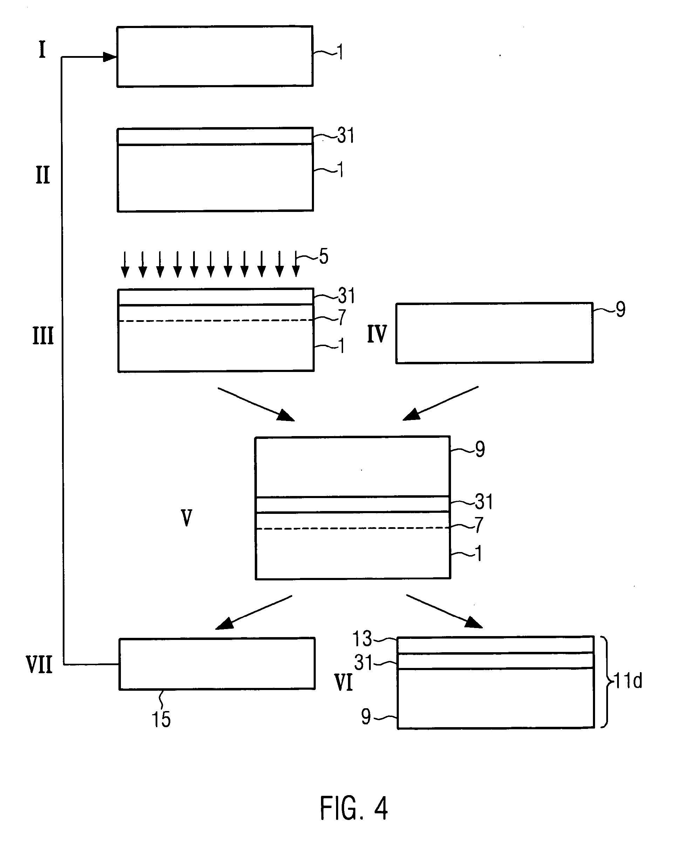

Figure 4 illustrates a fourth embodiment of the inventive method for manufacturing compound material wafers. Compared to the first embodiment the only difference in the method is in Step II during which the insulating layer 31 is provided on the donor substrate 1, as in this embodiment the insulating layer 31, in particular a Si02 layer, is not formed by thermal growth but by a deposition process. Due to the fact that the insulating layer 31 is a deposited layer, the thermal budget experienced by the donor substrate 1 can be kept low, even if an insulating layer with a thickness of more than 500Å is deposited. Like in the third embodiment, deposition is preferably carried out at temperatures of less than 750°C, more in particular, in a temperature range of 400°C - 600°C.

The remaining Steps III to VII correspond again to the ones described with respect to the first embodiment; their description is incorporated herewith by reference.

As the thermal budget seen by the donor substrate 1 can be kept lower, the crystalline quality is less affected than in the prior art, when the insulating layer is thermally grown to the same thickness. Thus the same advantages like in the first embodiment can be achieved, without the limitation of the thickness to 500 Å.

Preferably, after the detachment a thermal treatment step is carried out under neutral atmosphere to densify the insulating layer 31 of the compound material wafer 11 d, which in this embodiment comprises the handle substrate 9, the deposited and densified insulating layer 31 and the transferred layer 13, both being transferred from the donor substrate 1.

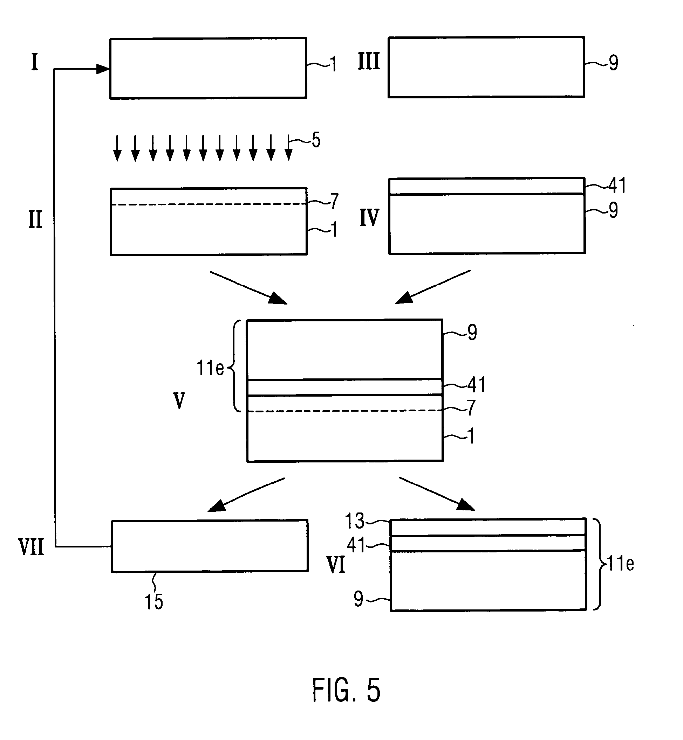

Figure 5 illustrates a fifth embodiment of the inventive method for fabricating a compound material wafer. Compared to the first four embodiments, the difference in this embodiment lies in the fact that no insulating layer is deposited on the donor substrate 1, but only on the handle substrate 9. Step I of the inventive method of the fifth embodiment corresponds to Step I of the previous embodiments, the same is valid for Step III which corresponds to Step IV in the previous embodiments. These steps will therefore not be described in detail again; their corresponding description is incorporated herewith by reference.

In Step II, like in Step III of the previous embodiments, atomic species 5, in particular, hydrogen or rare gas ions like helium, are implanted under predetermined dose and energy conditions into the donor substrate 1 to create a predetermined splitting area 7, however, in this embodiment without passing through an insulating layer, which as already mentioned above, is absent in this embodiment.

Step IV consists in forming a first insulating layer 41 over the handle substrate 9. This insulating layer 41 can be either a thermally grown one or a deposited one.

The subsequent Step V corresponds to step d) of claim 10, during which the donor substrate 1 attached, in particular bonded, to the insulating layer 41 provided over the handle substrate 9.

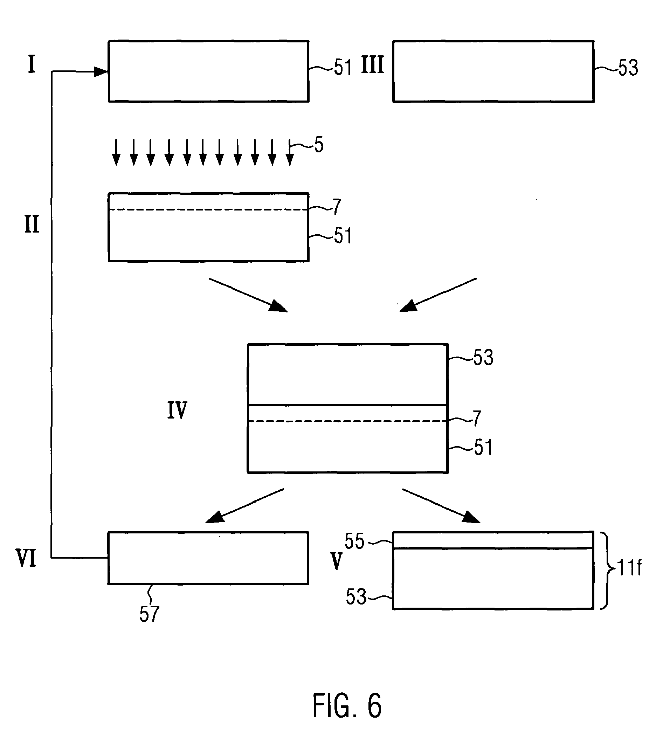

Then like in the previous embodiments, a detachment treatment is carried out during which detachment occurs at the predetermined splitting area 7 such that a silicon on insulator wafer 11 e is obtained, like illustrated in Figure 6. This compound material wafer 11e comprises the handle substrate 9, insulating layer 41 and a transferred layer 13 originating from the donor substrate 1.

Step VII corresponds to the Steps VII of the previous embodiments and will therefore not be described again in detail, but the corresponding description is incorporated herewith by reference.

Also with this embodiment, the same advantageous effects like in the previous embodiments can be achieved, as here the donor substrate is not subjected to a thermal treatment to obtain a first insulating layer. Thus the crystalline quality of the donor substrate can be kept high. As a consequence, the donor substrate can be reused several times, in particular, more than three times, even more in particular, five to ten times.

In the abovementioned cases whenever a thermal insulating layer is formed the oxidation temperature is preferably less than 850°C to keep the thermal budgets as low as possible, but due to the fact that the thickness of the layer deposited on the donor substrate is at most 500Å, it is also possible to form the layer at temperatures of 1000°C or more to speed up the process. For instance, to form a very thin oxide of 100Å on the donor substrate, a rapid thermal annealing and oxygen ambient atmosphere can be employed, thus a fast heating of the donor substrate from room temperature to about 1200°C, with more than 50°C/secs, holding that temperature for about 30 seconds and a rapid cooling down to room temperature, at more than 50°C/sec.

According to a variant of any of the first to fourth embodiment, the step of forming the predetermined splitting area 7 could also be carried out prior to forming any of the insulating layers, 3, 21 or 31.

In addition, according to variants of embodiments 1 to 5, further layers can be provided on the handle substrate or the second insulating layer on the handle substrate, as such layers do not affect the crystalline quality of the donor substrate. It is even possible to provide further additional layers on the first or third insulating layer on the donor substrate, as long as the thermal budget seen by the donor substrate during deposition of such additional layers remains low, so that the crystalline quality can be kept at a level still allowing the reuse of the wafer more than three times.

Figure 6 illustrates a sixth embodiment of the inventive method for fabricating a hybrid orientation wafer.

In contrast to the previous embodiments, this embodiment does not use any insulating layers. As a consequence, the donor substrate is not subject to a thermal layer forming treatment, which could negatively influence the crystalline quality of the donor substrate. Therefore also in this embodiment it is possible to reuse the donor substrate more than three times.

Step I of the method according to this embodiment consists in providing an initial donor substrate 51 which, according to step a) of claim 13, has a first crystal orientation. This can for example be a silicon wafer of (1,0,0) or (1,1,0)crystalline orientation.

Step II then illustrates the implantation of atomic species 5 into the donor substrate 51 to create a predetermined splitting area 7 in this substrate 51. The conditions under which implantation occurs are comparable to the ones of the previously described embodiments, their description is therefore incorporated herewith by reference.

Step III consists in providing a handle substrate 53 with a second crystal orientation, different to the one of the donor substrate 51. In Step IV, corresponding to step d) of claim 13, the donor substrate 51 is attached to the handle substrate 53, in particular by bonding. Attachment occurs such that the predetermined splitting area 7 is positioned towards the handle substrate 53.

Then a detachment treatment is carried out, like already described for the previous embodiments, the corresponding description of which is incorporated herewith by reference. As a consequence, in Step V a silicon on silicon hybrid orientation wafer 11f is obtained comprising a transferred layer 55 which originated from the donor substrate 51 having the first crystalline orientation and the handle substrate 53 with its second crystal orientation. Step VI then corresponds to Step VII of the previous embodiments, the detailed description of which is herewith incorporated by reference.

Such a hybrid orientation wafer 11f provides the possibility to optimize the electron or hole mobilities by taking into account the crystal orientation dependant mobilities of the carriers.

With the method according to the sixth embodiment it is also possible to reuse the remainder of the donor substrate 57 more than three times, in particular, five to ten times, as the donor substrate does not see the thermal budget linked to the provision of thermally grown insulating layers on the donor substrate like in the prior art. Thus, in the sixth embodiment the crystalline quality cannot be deteriorated due to thermal layer forming treatments on the donor substrate.

In case a natural oxide is present on the donor substrate 51 and/or handle substrate 53, this oxide can either be removed prior to attaching or removed by oxide dissolution once the attachment between the two substrates had already be achieved.

## Claims

1. Method for manufacturing compound material wafers, in particular silicon on insulator type wafers, comprising the steps:
a) providing a donor substrate (1),
b) forming a first insulating layer (3) over the donor substrate (1),
c) forming a predetermined splitting area (7) in the donor substrate (1),
d) attaching the donor substrate (1) onto a handle substrate (9), and
e) detaching the donor substrate (1) at the predetermined splitting area (7), thereby transferring a layer (13) of the donor substrate (1) onto the handle substrate (9) to form a compound material wafer (11)
**characterised in that**
the first insulating layer (3) is formed with a thickness of 500 Å or less and wherein the method is repeated more than three times, preferably five to ten times, wherein the donor substrate from which the layer (13) has been transferred, is reused as donor substrate.

2. Method according to claim 1, further comprising a step of forming a second insulating layer (17) over the handle substrate prior to step d).

3. Method according to claim 1 or 2, further comprising a step of depositing a third insulating layer (21) on the first insulating layer prior to step d).

4. Method according to one of claims 1 to 3, wherein the first insulating layer (3) is a thermal insulating layer formed by oxidation.

5. Method according to one of claims 1 to 4, wherein in step d) attachment occurs at the surface of the first insulating layer (3) or third insulating layer (21) of the donor substrate (1).

6. Method for manufacturing compound material wafers, in particular silicon on insulator type wafers, comprising the steps:
a) providing a donor substrate (1),
b) depositing a first insulating layer (31) over the donor substrate (1),
c) forming a predetermined splitting area (7) in the donor substrate (1),
d) attaching the donor substrate (1) onto a handle substrate (9), and
e) detaching the donor substrate (1) at the predetermined splitting area (7), thereby transferring a layer (13) of the donor substrate (1) onto the handle substrate (9) to form a compound material wafer (11d), and
wherein the method is repeated more than three times, preferably five to ten times, wherein the donor substrate from which the layer (13) has been transferred, is reused as donor substrate.

7. Method according to claim 3 or 6, further comprising a step f) of densifying, in particular by a thermal treatment under a neutral atmosphere, the deposited insulating layer (31) after step e).

8. Method according to claim 3, 6 or 7, wherein the depositing step is carried out at low temperature, in particular at less than 750°C, in particular in a range of 400°C to 600°C.

9. Method according to one of claims 6 to 8, wherein in step d) attachment occurs at the surface of the first insulating layer (31) of the donor substrate (1).

10. Method for manufacturing compound material wafers, in particular silicon on insulator type wafers, comprising the steps:
a) providing a donor substrate (1),
b) forming a predetermined splitting area (7) in the donor substrate (1),
c) providing a handle substrate (9),
d) forming a first insulating layer (41) over the handle substrate (9),
e) attaching the donor substrate (1) onto the first insulating layer (41), and
f) detaching the donor substrate (1) at the predetermined splitting area (7), thereby transferring a layer (13) of the donor substrate (1) onto the first insulating layer (41) over the handle substrate (9) to form a compound material wafer (11e), and
wherein the method is repeated more than three times, preferably five to ten times, wherein the donor substrate from which the layer (13) has been transferred, is reused as donor substrate.

11. Method according to claim 10, wherein in step e) attachment occurs at the surface of donor substrate (1).

12. Method according to one of claims 1 to 11, wherein the first insulating layer (3, 31, 41) and/or second insulating layer (17) and/or third insulating layer (21) is a silicon dioxide layer.

13. Method for manufacturing a hybrid orientation wafer, in particular silicon on silicon type wafer, comprising the steps:
a) providing a donor substrate (51) of a first crystal orientation,
b) forming a predetermined splitting area (7) in the donor substrate (51),
c) providing a handle substrate (53) with a different crystal orientation compared to the one of the donor substrate (51),
d) attaching the donor substrate (51) onto the handle substrate (53), and
e) detaching the donor substrate (51) at the predetermined splitting area (7), thereby transferring a layer (55) of the donor substrate (51) onto the handle substrate (53) to form a compound material wafer (11f), and
wherein the method is repeated more than three times, preferably five to ten times, wherein the donor substrate from which the layer (55) has been transferred, is reused as donor substrate.

14. Method according to claim 13, wherein in step d) attachment occurs directly at the surface of the donor substrate (51).

15. Reused donor substrate obtained during one of the methods according to one of claims 1 to 14.
